# EUROPÄISCHE PATENTSCHRIFT

(11) **EP 3 385 688 B1**
(45) Veröffentlichungstag und Bekanntmachung des Hinweises auf die Patenterteilung: **27.01.2021**
(21) Anmeldenummer: 18157980.6
(22) Anmeldetag: 22.02.2018
(51) Int. Cl.: G01K 1/14, H01L 23/34, G01K 13/02

(54) **KÜHLEINRICHTUNG, INSBESONDERE FÜR ELEKTRONIKBAUTEILE**
COOLING DEVICE, IN PARTICULAR FOR ELECTRONICS COMPONENTS
DISPOSITIF DE REFROIDISSEMENT, EN PARTICULIER POUR COMPOSANTS ÉLECTRONIQUES

(30) Priorität: 06.04.2017 DE 102017205857
(43) Veröffentlichungstag der Anmeldung: 10.10.2018
(73) Patentinhaber: AUDI AG, 85045 Ingolstadt (DE)
(72) Erfinder: Söhnle, Benjamin, 85051 Ingolstadt (DE)

(56) Entgegenhaltungen:
- DE-A1-102005 039 764
- DE-A1-102006 016 529
- DE-A1-102009 044 368
- US-A1- 2010 328 897

## Beschreibung

Die Erfindung betrifft eine Kühleinrichtung, insbesondere für Elektronikbauteile, umfassend einen Kühlkörper mit von einem Basiskörper abstehenden Kühlabschnitten, sowie einen am Kühlkörper vorgesehenen Temperatursensor.

Kühleinrichtungen der in Rede stehenden Art kommen insbesondere zum Kühlen von Bauelementen der Leistungselektronik zum Einsatz. Diese Bauelemente erzeugen im Betrieb mitunter viel Wärme, die abgeführt werden muss, um die Bauteile zu kühlen. Zu diesem Zweck wird eine Kühleinrichtung verwendet, mit einem Kühlkörper, mit dem das oder die zu kühlenden Elektronikbauteile thermisch gekoppelt sind, so dass seitens des oder der Bauteile entstehende Wärme auf den Kühlkörper übertragen wird. Der Kühlkörper weist einen Basiskörper, der die Elektronikbauteile trägt, auf. Vom Basiskörper stehen üblicherweise eine Mehrzahl separater Kühlabschnitte ab, um die Oberfläche zu vergrößern, an der der Wärmeübergang zum Umgebungsmedium erfolgt, mithin also die Wärme an die Umgebung abgeführt wird. Das Umgebungsmedium kann beispielsweise ein gasförmiges oder flüssiges Kühlmedium sein, das die Kühlabschnitte umgibt oder, wenn es aktiv gefördert wird, umströmt.

Am Kühlkörper ist zumeist ein Temperatursensor vorgesehen, mit dem die Temperatur des Kühlkörpers gemessen wird, wobei der entsprechende Messwert üblicherweise als Steuer- oder Regelgröße verwendet wird, um im Falle einer aktiven Kühlmediumförderung diese zu steuern und den Kühlkörper auf einem bestimmten Temperaturniveau zu halten. Da der Kühlkörper üblicherweise in einen Kühlmittelkreislauf eingebunden ist, in dem das Kühlmedium, sei es ein Gas, sei es ein Fluid, zirkuliert, wird üblicherweise der Temperatursensor durch eine Bohrung im Kühlkörper, die zum Hohlraum, in dem das Kühlmittel strömt, in die Bohrung eingeschraubt und mittels einer Dichtung abgedichtet. Dies ist aufwendig, insbesondere ist eine Dichtstelle gegeben, die im Laufe der Zeit möglicherweise zu Problemen führt.

Aus DE 698 03 041 T2 ist demgegenüber eine Kühleinrichtung bekannt, bei der der Temperatursensor in eine Sackbohrung im Basiskörper aufgenommen wird, die oberflächlich in den Basiskörper eingebracht ist. Dort wird die Temperatur des Basiskörpers, von dem aus sich lange, steg- oder rippenartige Kühlabschnitte erstrecken, gemessen.

Auch aus DE 20 2009 011 998 A1 ist eine Kühleinrichtung mit einem blockartigen Kühlkörper bekannt, in den ein Temperatursensor integriert ist.

Aus DE 102 25 602 A1 ist schließlich ein Halbleiterbauelement mit einer integrierten Schaltung bekannt, das auf einem Substrat angeordnet ist, wobei die dem Substrat abgewandte Seite der integrierten Schaltung des Halbleiterbauelements über eine wärmeleitende Schicht an einen Wärmeverteiler thermisch gekoppelt ist. An diesem Wärmeverteiler ist über eine elektrisch isolierende, jedoch thermisch gut leitende Schicht, die als thermische Ankopplungsschicht dient, ein Temperatursensor angeordnet, der als elektrischer Dünnschichtwiderstand ausgeführt ist. Hier befindet sich also der Temperatursensor an der Außenseite des eigentlichen Kühlkörpers.

Aus DE 10 2006 016 529 A1 ist eine Halbleiterstrahlungsquelle hoher Ausgangsleistungsdichte bekannt. Sie umfasst einen Träger mit einer darauf angeordneten zweidimensionalen Matrix aus Halbleiteremittern, wobei der Träger Teil eines von einem Kühlmittel durchströmten Gehäuses ist. In direktem Kontakt mit dem Kühlmittel steht ein Temperatursensor, dessen Messsignal einer Überwachungsschaltung gegeben wird. Über die Überwachungsschaltung kann ein Signal ausgegeben werden, wenn über das strömende Kühlmittel keine ausreichende Kühlung mehr gewährleistet werden kann, sodass die Halbleiteremitter rechtzeitig vor einer Beschädigung oder Zerstörung durch Reduzieren oder Abschalten ihres Speisestroms geschützt werden können.

Aus DE 10 2005 035 654 A1 ist ein Kühlsystem eines Stromhalbleitermoduls bekannt, umfassend einen Temperaturerfassungssensor, der in einem Halbleiterelement als Wärmequelle, das in einem Stromhalbleitermodul vorgesehen ist, angeordnet ist, und einen Controller, der eine Veränderung eines Wärmeübertragungskoeffizienten von dem Stromhalbleitermodul zu einem Kühlwasser, basierend auf einer Ausgabeinformation des Temperaturerfassungssensors und einer Antriebsinformation eines Drehzahlerfassungssensors für einen Pumpmotor zum Antreiben einer Kühlpumpe, abschätzt, den Pumpenmotor entsprechend dieses abgeschätzten Ergebnis steuert und die Kühlkapazität des Kühlwassers steuert.

Weiterhin ist aus US 4 975 766 A eine Anordnung zur Erfassung der Temperatur einer Chipanordnung bekannt, umfassend eine Platine mit darauf angeordneten integrierten Schaltungschips, von denen jeder auf einem Chipträger angeordnet ist, sowie umfassend eine Kühlplatte, die den Chips benachbart ist, und die als Wärmetauscher mit einem Kühlmittel dient. Ferner ist eine Temperaturerfassungseinrichtung vorgesehen, die ebenfalls auf der Platine angeordnet ist und die im Wesentlichen die gleiche Höhe wie die Chipträger aufweist. Diese Temperaturerfassungseinrichtung umfasst wenigstens einen Temperatursensor, der an einem Gehäuse angeordnet ist, wobei ferner ein wärmeleitendes Medium, das die schmalen Abstände, die zwischen der Kühlplatte und den Chips sowie der Temperaturerfassungseinrichtung füllt, vorgesehen ist.

Schließlich ist aus DE 10 2009 044 368 A1 eine Kühlanordnung zum Kühlen von zumindest einem elektrischen oder elektronischen Bauelement oder einer Bauelementengruppe unter Verwendung eines Kühlkörpers bekannt. Der Kühlkörper weist zumindest eine Aussparung auf, in welcher das zu kühlende Bauelement oder die Bauelementgruppe einführbar ist. In der Aussparung des Kühlkörpers ist ein Mittel eingebracht, dass das Bauelement oder die Bauelementgruppe im in die Aussparung eingeschobenen Zustand nahezu vollständig umgibt

Aus US 2010/328897 A1 ist weiterhin eine Kühleinrichtung zum Kühlen eines Halbleiterchips bekannt, die einen auf den Halbleiterchip montierten Grundkörper mit einer Vielzahl sich von diesem erstreckenden Kühlabschnitten aufweist, wobei einige der Kühlabschnitte und der Grundkörper eine Aussparung aufweisen, durch welche ein Temperatursensor zur Messung der Temperatur des Halbleiterchips hindurchgeführt werden kann.

Der Erfindung liegt damit das Problem zugrunde, eine Kühleinrichtung mit einer verbesserten Temperaturerfassungsmöglichkeit anzugeben.

Zur Lösung dieses Problems ist bei einer Kühleinrichtung der eingangs genannten Art erfindungsgemäß vorgesehen, dass der Temperatursensor in einer den Basiskörper durchsetzenden und sich in das Innere nur eines anschließenden Kühlabschnitts erstreckenden Ausnehmung angeordnet ist.

Während bei bisher bekannten Kühleinrichtungen der Temperatursensor entweder im Basiskörper in einer Sackbohrung oder an der Basiskörperaußenseite angeordnet ist, schlägt die Erfindung vor, diesen in einer Ausnehmung anzuordnen, die sich durch den Basiskörper bis in einen von diesem abstehenden Kühlabschnitt erstreckt, mit dem er kontaktiert ist. Wie beschrieben stehen üblicherweise vom Basiskörper eine Vielzahl von solchen Kühlabschnitten, die stiftartig sein können oder eine längliche rippen- oder stegartige Geometrie aufweisen können, ab. Sie werden zur Wärmeabfuhr üblicherweise von einem Kühlmittel, sei es Kühlluft, sei es eine Kühlflüssigkeit, umströmt, oder kommunizieren mit der Umgebungsluft. Über sie erfolgt der eigentliche Wärmetransport an die Umgebung, also die Abfuhr der Wärmemenge. Erfindungsgemäß ist nun vorgesehen, den Temperatursensor in einen solchen Kühlabschnitt zu integrieren, mithin also dort die Temperatur zu messen, die ein besseres Maß für den eigentlichen Kühlvorgang respektive die Wärmeabfuhr darstellt. Darüber hinaus wird sichergestellt, dass, nachdem es sich um eine geschlossene Ausnehmung handelt, die gerade nicht zur Umgebung hin offen ist, keine Dichtmaßnahmen zu treffen sind.

Der oder jeder Kühlabschnitt kann entweder als im Querschnitt runder oder mehreckiger, stiftartiger Kühlabschnitt ausgeführt sein. Vom Basiskörper stehen bei dieser Ausgestaltung also eine Vielzahl von voneinander etwas beabstandeten, einzelnen stiftartigen Kühlabschnitten ab, durch die beispielsweise das aktiv geförderte Kühlmittel durchströmt respektive das diese umströmt. Alternativ können der oder jeder Kühlabschnitt auch als längliche, rippen- oder stegartige Kühlabschnitte ausgeführt sein. Diese üblicherweise parallel zueinander und etwas beabstandet voneinander verlaufenden, plattenartigen Kühlabschnitte können ebenfalls in entsprechend großer Anzahl zur Vergrößerung der Oberfläche vorgesehen sein. Unabhängig davon, wie nun konkret der oder die Kühlabschnitte ausgeführt sind, weist der Kühlabschnitt eine entsprechende Breite oder Dicke auf, um die Ausnehmung einzubringen, wobei die Ausnehmung nicht allzu breit sein muss, da auch der Temperatursensor als sehr schmales Bauteil, beispielsweise umfassend ein eigenes, z. B. zylindrisches Gehäuse, ausgeführt werden kann.

Sind die Kühlabschnitte an sich sehr dünn oder schmal ausgeführt, um sie in möglichst hoher Anzahl an dem Basiskörper vorzusehen, kann es zweckmäßig sein, wenn sich der Kühlabschnitt, in den sich die Ausnehmung erstreckt, in dem mit der Ausnehmung versehenen Bereich etwas verbreitert ausgeführt ist. Das heißt, dass der Kühlabschnitt, in den der Temperatursensor integriert werden soll, von seiner Geometrie her etwas anders ausgeführt ist als die anderen Kühlabschnitte, er ist im Bereich, mit dem er an den Basiskörper anschließt, etwas verbreitert ausgeführt. Eine solche quasi individuelle Ausgestaltung eines Kühlabschnitts ist ohne weiteres möglich, da es sich bei dem Kühlkörper beispielsweise um ein Metallgussteil handelt, so dass eine entsprechende individuelle Formgebung ohne weiteres realisierbar ist. Weisen die Kühlabschnitte jedoch grundsätzlich eine hinreichende Breite auf, somit also auch der Kühlabschnitt, in dem der Temperatursensor integriert ist, so kann er über seine ganze Länge eine gleichbleibende Geometrie aufweisen.

Die Ausnehmung selbst ist bevorzugt als zylindrische Bohrung ausgeführt, was die Einbringung der Ausnehmung sehr einfach macht. Auch der Temperatursensor kann als längliches Sensorbauteil mit einem stiftartigen Gehäuse ausgeführt sein, so dass er ohne weiteres in die Ausnehmung eingeführt werden kann.

Der Temperatursensor kann, beispielsweise über sein längliches Gehäuse, in die Ausnehmung lediglich eingesteckt sein, wenn sichergestellt ist, dass er aufgrund sonstiger baulicher Maßnahmen wie beispielsweise der Halterung in einem zum Kühlkörper externen Halter oder dergleichen in der Ausnehmung unbeweglich aufgenommen ist. Denkbar ist es aber auch, den Temperatursensor in der Ausnehmung zu verkleben, ihn also dort über eine Klebeverbindung zu fixieren. Ein Vergießen oder Abdichten ist, wie bereits beschrieben, nicht erforderlich.

Besonders bevorzugt weist der Kühlkörper einen von dem Kühlmedium durchströmbaren Hohlraum auf, dessen eine Seite von dem Basiskörper begrenzt ist, wobei sich die Kühlabschnitte in den Hohlraum erstrecken. In diesem Fall wird eine aktive Kühlung vorgesehen, indem in den Kühlkörper aktiv ein Kühlmedium wie eine Kühlflüssigkeit oder ein Kühlgas eingeführt und wieder abgezogen wird. Der Kühlkörper kann also ohne weiteres in einem entsprechenden Kühlkörperkreislauf integriert werden. Die Kühlabschnitte werden, nachdem sie sich in den Hohlraum erstrecken, von dem Kühlmedium umströmt, mithin auch der den Temperatursensor aufweisende Kühlabschnitt, so dass über den Temperatursensor die exakte Temperatur, wie sie sich durch die Kühlung ergibt, erfasst werden kann.

Bevorzugt erstrecken sich die Kühlabschnitte bis zu einer die gegenüberliegende Seite des Hohlraums begrenzenden Kühlkörperwand. Sie können sich bis kurz davor erstrecken und über einen schmalen Spalt beabstandet sein, sie können aber auch daran anliegen, mithin also damit thermisch gekoppelt sein, was für den Wärmeübertrag noch besser ist.

Zum Zu- und Abführen eines Kühlmediums ist an dem Kühlkörper respektive dem Kühlkörpergehäuse wenigstens ein Zulaufanschluss und wenigstens ein Ablaufanschluss, die zum Hohlraum führen, für das Kühlmedium führende Leitungen vorgesehen.

Der Kühlkörper selbst ist bevorzugt aus Metall, insbesondere Aluminium gefertigt, wobei dies jedoch nicht zwingend ist.

Neben der Kühleinrichtung selbst betrifft die Erfindung ferner eine Elektronikanordnung, umfassend ein oder mehrere Elektronikbauteile sowie wenigstens eine Kühleinrichtung der beschriebenen Art. Das oder die Elektronikbauteile sind zweckmäßigerweise in direktem thermischen Kontakt an dem Basiskörper angeordnet, was beispielsweise durch Ankleben oder dergleichen mit einem thermisch leitfähigem Kleber oder ähnlichem erfolgen kann.

Des Weiteren ist zweckmäßigerweise eine Steuerungseinrichtung umfassend eine Schaltungsplatine vorgesehen, die mit dem Temperatursensor verbunden ist.

Weitere Vorteile und Einzelheiten der Erfindung ergeben sich aus den im Folgenden beschriebenen Ausführungsbeispielen sowie anhand der Zeichnungen. Dabei zeigen:
- Fig. 1: eine Prinzipdarstellung einer erfindungsgemäßen Kühleinrichtung einer ersten Ausführungsform, und
- Fig. 2: eine Prinzipdarstellung einer erfindungsgemäßen Elektronikanordnung mit einer Kühleinrichtung einer zweiten Ausführungsform.

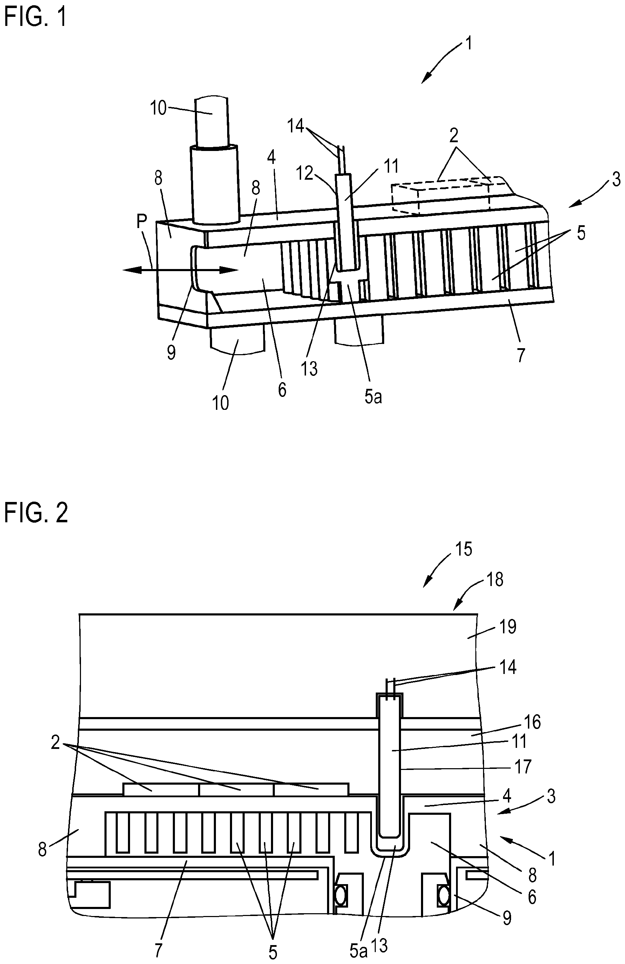

Fig. 1 zeigt eine erfindungsgemäße Kühleinrichtung 1, die exemplarisch zum Kühlen von hier nur gestrichelt gezeigten Elektronikbauteilen 2 dient. Die Kühleinrichtung 1 umfasst einen Kühlkörper 3, bestehend aus einem Basiskörper 4, der quasi plattenartig ausgeführt ist, und auf dem das oder die Elektronikbauteile thermisch gekoppelt angeordnet sind. Vom Basiskörper 4 erstrecken sich eine Vielzahl einzelner Kühlabschnitte 5 ab, die im gezeigten Beispiel stiftartig ausgeführt sind und exemplarisch einen runden Querschnitt aufweisen. Sie sind in Längs- und Querrichtung geringfügig voneinander beabstandet, so dass ein zugeführtes Kühlmittel, beispielsweise Kühlwasser, sämtliche Kühlabschnitte 5 umströmen kann.

Es ist ein Hohlraum 6 gebildet, der über eine untere Kühlkörperwand 7 abgeschlossen ist, wobei der Kühlkörper 3 natürlich auch vorder- und rückseitig sowie an den Seiten entsprechend geschlossen ist, was beispielsweise über entsprechende Seitenwandabschnitte des Basiskörpers 4 realisiert werden kann. Zwei solcher Seitenabschnitte 8 sind exemplarisch in Fig. 1 gezeigt.

Ersichtlich erstrecken sich die Kühlabschnitte 5 über die gesamte Höhe des Hohlraums 6, exemplarisch liegen sie an der unteren Kühlkörperwand 7 an, so dass auch dort ein thermischer Kontakt gegeben ist.

Die Kühlmittelzufuhr erfolgt über einen Anschluss 9, an dem eine Zulauf- und/oder Ablaufleitung angeschlossen werden kann. Wie durch den Doppelpfeil P dargestellt kann über den einen Anschluss, der quasi ein kombinierter Anschluss ist, sowohl der Zulauf als auch der Ablauf des Kühlmittels erfolgen. Denkbar wäre es aber auch an der gegenüberliegenden Seitenwand einen entsprechenden Anschluss vorzusehen, so dass der eine Anschluss der Zu- und der andere Anschluss der Ablauf ist.

Des Weiteren sind am Kühlkörper 3 exemplarisch verschiedene Befestigungsabschnitte 10 dargestellt, die seine Montage an Umgebungsbauteilen ermöglichen.

Vorgesehen ist des Weiteren ein Temperatursensor 11, der hier stiftartig ausgeführt ist und beispielsweise ein zylindrisches Gehäuse 12 aufweist. Der Temperatursensor 11 ist in eine beispielsweise ebenfalls zylindrische Ausnehmung 13 eingesetzt. Diese erstreckt sich durch den Basiskörper 4 bis hinein in den Kühlabschnitt 5a, der ersichtlich in seinem an den Basisabschnitt 4 angrenzenden Bereich etwas verbreitert ausgeführt ist. Das heißt, dass sich der Temperatursensor 11 mit seinem Messbereich quasi im Inneren des Hohlraums in den Kühlabschnitt 5a integriert befindet. Der Kühlabschnitt 5a wird, wie auch die anderen Kühlabschnitte 5, natürlich vom Kühlmedium umströmt. Der Temperatursensor 11 misst nun die Temperatur des mit ihm kontaktierten Kühlabschnitts 5a, was ein sehr gutes Maß für den Grad der Wärmeabfuhr respektive der Kühlung ist.

Der Temperatursensor weist im gezeigten Beispiel Anschlussleitungen 14 auf, die es ermöglichen, ihn mit einer zugeordneten Steuer- oder Verarbeitungselektronik zu verbinden, wobei beispielsweise der Betrieb der Kühlmittelzufuhr in Abhängigkeit der Temperaturerfassung über den Temperatursensor 11 gesteuert wird.

Fig. 2 zeigt ein Ausführungsbeispiel einer Elektronikanordnung 15, umfassend eine erfindungsgemäße Kühleinrichtung 1 mit dem Kühlkörper 3. Auch dieser weist einen Basiskörper 4 auf, von dem eine Vielzahl einzelner Kühlabschnitte 5 abstehen. Wiederum ist ein Hohlraum 6 gebildet, nachdem der Basiskörper 4, der zum seitlichen Abschluss auch hier Seitenwände 8 aufweist, unterseitig über eine Kühlkörperwand 7 geschlossen ist. Bei dieser Ausgestaltung ist die Kühlkörperwand 7 mit dem Anschluss 9 für eine Zulauf- und/oder Ablaufleitung, auch hier gegebenenfalls eine kombinierte Leitung, versehen, so dass ein Kühlmittel durch den Hohlraum 6 zirkulieren kann.

Vorgesehen ist wiederum ein Kühlabschnitt 5a, der bei dieser Ausgestaltung verbreitert, verglichen mit den Kühlabschnitten 5, ausgeführt ist, und in den sich die Ausnehmung 13, den Basiskörper 4 ebenfalls durchsetzend, erstreckt. In ihm ist der Temperatursensor 11 aufgenommen, wie Fig. 2 deutlich zeigt.

Auch hier befindet sich also der Temperatursensor 11 tief im Inneren des Hohlraums 6 in einem unmittelbar vom Kühlmedium umströmten Kühlabschnitt 5a, so dass dessen Ist-Temperatur gemessen wird.

In Fig. 2 sind des Weiteren Elektronikbauteile 2 exemplarisch dargestellt, bei denen es sich beispielsweise um Leistungshalbleiter handelt. Sie sind unmittelbar auf dem Basiskörper 4, also dem Kühlkörper 3 angeordnet, befinden sich also in direktem thermischen Kontakt, so dass die bei ihrem Betrieb erzeugte Wärme unmittelbar an den Kühlkörper 3 übertragen und über die Kühlabschnitte 5, 5a an das Kühlmedium abgegeben werden kann.

Des Weiteren dargestellt ist ein Halter 16, beispielsweise ein Kunststoffrahmen oder Ähnliches, der eine entsprechende Bohrung 17 aufweist, in die der Temperatursensor 11 eingesetzt ist. In dieser ist er beispielsweise fixiert, beispielsweise verklebt, so dass er positionsfest in seiner Anordnung in der Ausnehmung 13 fixiert ist.

Dargestellt ist des Weiteren eine Steuer- oder Verarbeitungselektronik 18, die hier nur dem Grunde nach dargestellt ist, umfassend eine Platine 19 mit entsprechenden Anschlussmöglichkeiten. Der Temperatursensor 11 ist über seine Anschlussleitungen 14 mit der entsprechenden Steuer- oder Verarbeitungselektronik 18 gekoppelt, es ist bevorzugt eine Direktkontaktierung vorgesehen, so dass die Steuer- oder Verarbeitungselektronik die vom Temperatursensor 11 gegebenen Messsignale umgehend verarbeiten und umsetzen kann.

Wenngleich in Fig. 1 und 2 stiftartige Kühlabschnitte 5, 5a gezeigt sind und insbesondere auch der Kühlabschnitt 5a, in den der Temperatursensor 11 integriert ist, stiftartig ausgeführt ist, ist es selbstverständlich denkbar, die Kühlabschnitte 5, 5a auch rippen- oder stegartig, also als längliche, plattenförmige Kühlabschnitte, die parallel zueinander verlaufen, auszugestalten.

Der Kühlkörper 3 insgesamt ist bevorzugt aus Metall, vorzugsweise Aluminium, das einen hohen Wärmeleitkoeffizienten aufweist und für die Kühlung vorteilhaft ist.

## Patentansprüche

1. Kühleinrichtung, insbesondere für Elektronikbauteile, umfassend einen Kühlkörper (3) mit mehreren von einem Basiskörper (4) abstehenden Kühlabschnitten (5, 5a), sowie einen am Kühlkörper (3) vorgesehenen Temperatursensor (11),
**dadurch gekennzeichnet,**
**dass** der Temperatursensor (11) in einer den Basiskörper (4) durchsetzenden und sich in das Innere nur eines anschließenden Kühlabschnitts (5a) erstreckenden Ausnehmung (13) angeordnet ist.

2. Kühleinrichtung nach Anspruch 1,
**dadurch gekennzeichnet,**
**dass** der die Ausnehmung (13) aufweisende Kühlabschnitt (5a) oder jeder Kühlabschnitt (5, 5a) als im Querschnitt runder oder mehreckiger stiftartiger oder als länglicher rippen- oder stegartiger Kühlabschnitt (5, 5a) ausgeführt ist.

3. Kühleinrichtung nach Anspruch 1 oder 2,
**dadurch gekennzeichnet,**
**dass** der Kühlabschnitt (5a), in den sich die Ausnehmung (13) erstreckt, in dem mit der Ausnehmung (13) versehenen Bereich verbreitert ausgeführt ist, oder dass der Kühlabschnitt (5a), in den sich die Ausnehmung (13) erstreckt, über seine ganze Länge eine gleichbleibende Breite aufweist.

4. Kühleinrichtung nach einem der vorangehenden Ansprüche,
**dadurch gekennzeichnet,**
**dass** die Ausnehmung (13) als zylindrische Bohrung ausgeführt ist.

5. Kühleinrichtung nach einem der vorangehenden Ansprüche,
**dadurch gekennzeichnet,**
**dass** der Temperatursensor (11) als längliches Sensorbauteil mit einem stiftartigen Gehäuse (12) ausgeführt ist.

6. Kühleinrichtung nach einem der vorangehenden Ansprüche,
**dadurch gekennzeichnet,**
**dass** der Temperatursensor (11) in der Ausnehmung verklebt ist.

7. Kühleinrichtung nach einem der vorangehenden Ansprüche,
**dadurch gekennzeichnet,**
**dass** der Kühlkörper (3) einen von einem Kühlmedium durchströmbaren Hohlraum (6) aufweist, dessen eine Seite von dem Basiskörper (4) begrenzt ist, wobei sich die Kühlabschnitte (5, 5a) in den Hohlraum (6) erstrecken.

8. Kühleinrichtung nach Anspruch 7,
**dadurch gekennzeichnet,**
**dass** sich die Kühlabschnitte (5, 5a) bis zu einer die gegenüberliegende Seite begrenzenden Kühlkörperwand (7) erstrecken.

9. Kühleinrichtung nach Anspruch 7 oder 8,
**dadurch gekennzeichnet,**
**dass** wenigstens ein Zulaufanschluss (9) und wenigstens ein Ablaufanschluss für das Kühlmedium führende Leitungen vorgesehen ist.

10. Kühleinrichtung nach einem der vorangehenden Anspruche,
**dadurch gekennzeichnet,**
**dass** der Kühlkörper (3) aus Metall, insbesondere Aluminium ist.

11. Elektronikanordnung, umfassend ein oder mehrere Elektronikbauteile (2) sowie eine Kühleinrichtung (1) nach einem der vorangehenden Ansprüche.

12. Elektronikanordnung nach Anspruch 11,
**dadurch gekennzeichnet,**
**dass** das oder die Elektronikbauteile (2) in direktem thermischen Kontakt an dem Basiskörper (4) angeordnet sind.

13. Elektronikanordnung nach Anspruch 11 oder 12,
**dadurch gekennzeichnet,**
**dass** eine Steuerungseinrichtung (18) umfassend eine Schaltungsplatine (19) vorgesehen ist, wobei die Schaltungsplatine (19) mit dem Temperatursensor (11) verbunden ist.

## Claims

1. Cooling apparatus, in particular for electronic components, comprising a heat sink (3) with several cooling sections (5, 5a) protruding from a base body (4), and a temperature sensor (11) provided on the heat sink (3),
**characterised in that**
the temperature sensor (11) is arranged in a recess (13) penetrating the base body (4) and extending into the interior of only one adjoining cooling section (5a).

2. Cooling apparatus according to claim 1,
**characterised in that**
the cooling section (5a) having the recess (13) or each cooling section (5, 5a) is designed as a pin-like cooling section with a round or polygonal cross-section or as an elongated ribbed or web-like cooling section (5, 5a).

3. Cooling apparatus according to claim 1 or 2,
**characterised in that**
the cooling section (5a) into which the recess (13) extends is widened in the region provided with the recess (13), or **in that** the cooling section (5a) into which the recess (13) extends has a constant geometry over its entire length.

4. Cooling apparatus according to any of the preceding claims,
**characterised in that**
the recess (13) is designed as a cylindrical bore.

5. Cooling apparatus according to any of the preceding claims,
**characterised in that**
the temperature sensor (11) is designed as an elongated sensor component with a pin-like housing (12).

6. Cooling apparatus according to any of the preceding claims,
**characterised in that**
the temperature sensor (11) is glued in the recess.

7. Cooling apparatus according to any of the preceding claims,
**characterised in that**
the heat sink (3) has a cavity (6) through which a cooling medium can flow and one side of which is delimited by the base body (4), wherein the cooling sections (5, 5a) extend into the cavity (6).

8. Cooling apparatus according to claim 7,
**characterised in that**
the cooling sections (5, 5a) extend as far as a heat sink wall (7) delimiting the opposite side.

9. Cooling apparatus according to claim 7 or 8,
**characterised in that**
at least one inlet connection (9) and at least one outlet connection are provided for pipes carrying the cooling medium.

10. Cooling apparatus according to any of the preceding claims,
**characterised in that**
the heat sink (3) is made of metal, in particular aluminium.

11. Electronic arrangement, comprising one or more electronic components (2) and a cooling apparatus (1) according to any of the preceding claims.

12. Electronic arrangement according to claim 11,
**characterised in that**
the electronic component(s) (2) are arranged in direct thermal contact with the base body (4).

13. Electronic arrangement according to claim 11 or 12,
**characterised in that**
a control apparatus (18) comprising a circuit board (19) is provided, wherein the circuit board (19) is connected to the temperature sensor (11).

## Revendications

1. Appareil de refroidissement, en particulier pour des composants électroniques, comprenant un dissipateur thermique (3) avec plusieurs sections de refroidissement (5, 5a) dépassant d'un corps de base (4), ainsi qu'un capteur de température (11) prévu sur le dissipateur thermique (3),
**caractérisé en ce que**
le capteur de température (11) est agencé dans un évidement (13) traversant le corps de base (4) et s'étendant dans l'intérieur de seulement une section de refroidissement reliée (5a).

2. Appareil de refroidissement selon la revendication 1,
**caractérisé en ce que**
la section de refroidissement (5a) présentant l'évidement (13) ou chaque section de refroidissement (5, 5a) est conçue comme une section de refroidissement en forme de tige de section transversale ronde ou polygonale, ou comme une section de refroidissement (5, 5a) allongée en forme de nervure ou de bande.

3. Appareil de refroidissement selon la revendication 1 ou 2,
**caractérisé en ce que**
la section de refroidissement (5a), dans laquelle s'étend l'évidement (13), est conçue de manière élargie dans la zone pourvue de l'évidement (13), ou **en ce que** la section de refroidissement (5a) dans laquelle s'étend l'évidement (13) présente une largeur restant constante sur toute sa longueur.

4. Appareil de refroidissement selon l'une quelconque des revendications précédentes,
**caractérisé en ce que**
l'évidement (13) est conçu comme un trou cylindrique.

5. Appareil de refroidissement selon l'une quelconque des revendications précédentes,
**caractérisé en ce que**
le capteur de température (11) est conçu comme un composant de capteur allongé avec un boîtier en forme de tige (12).

6. Appareil de refroidissement selon l'une quelconque des revendications précédentes,
**caractérisé en ce que**
le capteur de température (11) est collé dans l'évidement.

7. Appareil de refroidissement selon l'une quelconque des revendications précédentes,
**caractérisé en ce que**
le dissipateur thermique (3) présente une cavité (6) pouvant être traversée par un fluide de refroidissement, dont un côté est limité par le corps de base (4), dans lequel les sections de refroidissement (5, 5a) s'étendent dans la cavité (6).

8. Appareil de refroidissement selon la revendication 7,
**caractérisé en ce que**
les sections de refroidissement (5, 5a) s'étendent jusqu'à une paroi de dissipateur thermique (7) limitant le côté opposé.

9. Appareil de refroidissement selon la revendication 7 ou 8,
**caractérisé en ce qu'**
au moins un orifice d'alimentation (9) et au moins un orifice de vidange sont prévus pour les tuyaux guidant le fluide de refroidissement.

10. Appareil de refroidissement selon l'une quelconque des revendications précédentes,
**caractérisé en ce que**
le dissipateur thermique (3) est en métal, en particulier en aluminium.

11. Agencement électronique, comprenant un ou plusieurs composants électroniques (2) ainsi qu'un appareil de refroidissement (1) selon l'une quelconque des revendications précédentes.

12. Agencement électronique selon la revendication 11,
**caractérisé en ce que**
le ou les composants électroniques (2) sont agencés en contact thermique direct avec le corps de base (4).

13. Agencement électronique selon la revendication 11 ou 12,
**caractérisé en ce qu'**
un appareil de commande (18) comprenant une carte de circuit imprimé (19) est prévu, dans lequel la carte de circuit imprimé (19) est reliée au capteur de température (11).
